# EUROPÄISCHE PATENTANMELDUNG

(11) **EP 0 907 265 A2**
(43) Veröffentlichungstag der Anmeldung: **07.04.1999**
(21) Anmeldenummer: 98116409.8
(22) Anmeldetag: 29.08.1998
(51) Int. Cl.: H04H 1/00, H03J 1/00

(54) **RDS-Rundfunkempfänger mit Alternativfrequenzspeicher und Verfahren zur Speicherorganisation**

(30) Priorität: 02.10.1997 DE 19743645
(71) Anmelder: ROBERT BOSCH GMBH, 70442 Stuttgart (DE)
(72) Erfinder: Bieber, Detlef, 31137 Hildesheim (DE); Groeger, Klaus-Erwin, 31199 Diekholzen (DE)

(57) **Zusammenfassung**

Die Erfindung betrifft ein Verfahren zum Ablegen und Sortieren von Alternativfrequenzen AF in einem Alternativfrequenzspeicher (AF-Speicher) eines RDS-Rundfunkempfängers sowie einen RDS-Rundfunkempfänger mit Alternativfrequenzspeicher. Hierbei wird eine im RDS-Signal zusätzlich vorhandene PTY-Kennung im AF-Speicher zusätzlich abgespeichert und als Sortierkriterium für die AF im AF-Speicher und als Auswahlkriterium verwendet.

## Beschreibung

### Technisches Gebiet

Die Erfindung betrifft ein Verfahren zum Ablegen und Sortieren von Alternativfrequenzen (AF) in einem Alternativfrequenzspeicher (AF-Speicher) eines Rundfunkempfängers mit Auswerteeinheit für das Radio-Daten-System (RDS-Rundfunkempfänger). Die Erfindung betrifft ferner einen RDS-Rundfunkempfänger mit Alternativfrequenzspeicher.

### Stand der Technik

Bei Rundfunkempfängern mit Auswerteeinheit für das Radio-Daten-System (RDS-Rundfunkempfänger), wie beispielsweise RDS-Autoradios, ist es bekannt, bei schlechter Signal- bzw. Empfangsqualität einen Test für Alternativfrequenzen (AF-Test) durchzuführen und ggf. auf eine Alternativfrequenz (AF) zu wechseln, wenn sich dort eine bessere Signal- bzw. Empfangsqualität ergibt.

Das Signal des Radio-Daten-System (RDS), ein sogenanntes RDS-Signal, dient bei Programmausstrahlungen, beispielsweise von Radioprogrammen für Reisende in einem Kraftfahrzeug, welches mit einem entsprechendem RDS-Autoradio ausgestattet ist, zur Übermittlung verschiedener wichtiger Informationen, mit denen das RDS-Autoradio eine Vielzahl von für einen ungestörten Empfang nötige Operationen selbständig und automatisiert ausführt, ohne daß beispielsweise ein Fahrer seine Aufmerksamkeit vom Straßenverkehr abwenden und manuelle Eingaben am RDS-Autoradio durchführen muß. Ferner enthält dieses RDS-Signal Informationen, die ggf. auf einer Anzeige des RDS-Autoradios dem Fahrer bzw. einem Benutzer mitgeteilt werden.

Das RDS-Signal ist in einer EBU-Spezifikation DIN EN50067 spezifiziert und enthält bzw. überträgt mit dem Sendersignal auf einer momentan eingestellten Frequenz eines momentan am RDS-Autoradio eingestellten Rundfunksenders, nachfolgend auch Mutterfrequenz oder kurz MF genannt, beispielsweise eine Alternativfrequenz-Liste, welche Alternativfrequenzen (AF) des momentan eingestellten Rundfunksenders enthält. Diese AF sind Frequenzen von anderen Sendern, die zu einer Senderkette des momentan eingestellten Rundfunksenders gehören. Beispielsweise Sender, welche das Rundfunkprogramm von NDR2 ausstrahlen.

Zur Differenzierung der verschiedenen Rundfunksender mit entsprechend unterschiedlichen Senderketten enthält das RDS-Signal des momentan eingestellten Rundfunksenders zusätzlich ein Programmidentifikations-Code, nachfolgend PI-Code oder kurz PI genannt. Dieses besteht gemäß der EBU-Spezifikation DIN EN50067 aus 4 Stellen, die auch 1. Nibble bis 4. Nibble genannt werden. Das 1. Nibble kennzeichnet das Land, z.B. "D" für Deutschland oder "F" Frankreich. Das 2. Nibble kennzeichnet, ob es sich um einen supraregionalen, nationalen oder regionalen Sender handelt. Das 3. Nibble kennzeichnet die Senderkette, z.B. "8" für NDR. Das 4. Nibble unterscheidet das jeweilige Programm der Senderkette, z.B. NDR1, NDR2, NDR3, NDR 4 usw. der Senderkette des Norddeutschen Rundfunks NDR.

Zusätzlich enthält das RDS-Signal einen Programm-Namen, beispielsweise "NDR1", "NDR2" oder "NDR3", welcher nachfolgend kurz mit PS (Programm Service Name) bezeichnet wird.

Bei schlechter Signal- bzw. Empfangsqualität führt das RDS-Autoradio automatisch einen Test für Alternativfrequenzen (AF-Test) durch und wechselt ggf. auf eine Alternativfrequenz (AF), wenn sich dort eine bessere Signal- bzw. Empfangsqualität ergibt. Eine bessere Empfangsqualität ist beispielsweise, aber nicht notwendigerweise, durch eine höhere Feldstärke gegeben. Tatsächlich führen auch Effekte wie Mehrwegeempfang, RDS-Datenfehlerrate beim Empfang oder Nachbarkanalstörungen teilweise unabhängig von der Feldstärke des Empfangssignals zu Beeinträchtigungen der Empfangsqualität. Die beste Empfangsqualität ergibt sich dabei aus einer Summe aller Parameter, die die Empfangsqualität widerspiegeln, wie beispielsweise Feldstärke, Mehrwegeempfang-Feldstärken, Datenfehlerrate, Nachbarkanalstörungen. Diese Summe wird unter ggf. variabler Gewichtung der verschiedenen Parameter gebildet und ergibt einen Wert, welcher ein Maß für die Empfangsqualität ist.

Diese Gewichtung ist beispielsweise länderspezifisch. So ist z.B. in Frankreich der Signalhub sehr hoch, jedoch das NF-Signal dadurch mit hohen Störungen behaftet, wohingegen das RDS-Signal sehr gut detektierbar ist. Hier bekommt beispielsweise die Feldstärke ein niedrigeres Gewicht. Somit kann es vorkommen, daß eine AF mit in der Gesamtwertung lediglich drittstärksten Feldstärke des empfangenen Sendersignals momentan die beste Empfangsqualität bietet. Nachfolgend bezeichnet "beste PI" diejenige zu dem PI-Code gehörende AF, welche für den momentan gewählten Sender die beste Empfangsqualität bietet.

Der RDS-Rundfunkempfänger verwaltet die ihm bekannten Alternativfrequenzen beispielsweise in absteigender Reihenfolge bezüglich des oben erläuterten Wertes für die Empfangsqualität nach unterschiedlichen Systemen, so daß bei Verschlechterung der Empfangsqualität des momentan eingestellten Senders möglichst immer auf eine qualitativ bessere AF gewechselt werden kann.

Hierbei ist ein wesentliches Kriterium, daß die AF dasselbe Programm ausstrahlt, wie der momentan eingestellte Rundfunksender, da ein Programmwechsel nicht erwünscht ist. Vielmehr soll trotz unterschiedlicher Empfänger-Standorte, beispielsweise eines RDS-Autoradios in einem fahrenden Kraftfahrzeug, solange wie irgend möglich das einmal vom Benutzer gewählte Programm einer Senderkette mit für den jeweiligen Standort des RDS-Rundfunkempfängers optimaler Qualität hörbar sein. Hierzu prüft der RDS-Rundfunkempfänger den PI-Code für eine bestimmte AF und vergleicht den erhaltenen PI-Code mit demjenigen des momentan eingestellten Senders. Ist diese Überprüfung erfolgt, so wird diese PI im Nachfolgenden als eine "geprüfte PI" bezeichnet. Stimmen die PI-Codes überein, so wird im Nachfolgenden von einer "gültigen AF" gesprochen. Stimmen die PI-Codes nicht überein, so wird im nachfolgenden von einer "verbotenen AF" gesprochen.

Beim Prüfen des PI-Codes muß der RDS-Rundfunkempfänger kurz von der momentan eingestellten Frequenz auf die zu prüfende bzw. neu einzumessende und bewertende AF wechseln. Um einen unerwünschten Lautstärkesprung bzw. kurzen Wechsel in der vom RDS-Rundfunkempfänger über Lautsprecher abgegebenen Niederfrequenz zu vermeiden, wird während der kurzen Umschaltung die Lautsprecherausgabe stumm geschaltet, was nachfolgend als "Muten" bezeichnet wird. Nach dem Nuten wird, je nach Ergebnis der Prüfung des PI-Codes, entweder die neu bewertete AF in der Alternativfrequenz-Liste an eine Stelle entsprechend der Empfangsqualität zu den anderen in der Liste befindlichen Signalen einsortiert und die Lautsprecherausgabe auf der ursprünglichen Frequenz wieder freigegeben oder die AF verworfen und die Lautsprecherausgabe auf der ursprünglichen Frequenz wieder freigegeben oder auf der geprüften neuen AF die Lautsprecherausgabe wieder freigegeben.

RDS-Geräte neuerer Generationen weisen einen sogenannten Hintergrundspeicher auf, welcher auch als Landschaftsspeicher, Blätterspeicher oder PI-Mem bezeichnet wird. In diesem Alternativfrequenzspeicher (AF-Speicher) sind alle identifizierten Sender und zugehörige Alternativfrequenzen (AF) mit der zuletzt abgestimmten Mutterfrequenz (MF) alphanumerisch den Programmidentifikations-Codes (PI) entsprechend sortiert abgelegt. Diese AF-Speicher werden gepflegt, sortiert und fortgeschrieben beispielsweise sobald neue Alternativfrequenzen (AF) identifiziert werden.

Ausgehend von dem eingestellten Sender kann z. B. mit der Handabstimmwippe der nächste Sender der PI-Kennung aufwärts/abwärts folgend aufgerufen werden. Ferner kann die Einstellung einer Alternativfrequenz (AF) beispielsweise automatisch erfolgen, wenn die Empfangsqualität des momentan eingestellten Rundfunksenders ein vorbestimmtes Mindestmaß unterschreitet. Die Alternativfrequenz beispielsweise mit der momentan größten Feldstärke wird abgestimmt und wenn nicht bereits geschehen, eine PI-Prüfung durchgeführt. Bei Bestätigen der PI als gültige PI wird das Rundfunksignal laut geschaltet. Falls sich trotz PI-Gleichheit der Sendername (PS) geändert hat, wird eine Anzeige entsprechend angepaßt.

Die Vielzahl der verfügbaren Sender und Programme macht jedoch eine gezielte Auswahl des gewünschten Programms in fremden Gebieten unmöglich. Es ist meist nicht bekannt, welche Programmart, wie beispielsweise Musik, Sport oder Nachrichten, die einzelnen Programme, wie beispielsweise NDR1, NDR2 oder NDR3 der Sendeanstalt NDR, oder Programmanbieter, wie beispielsweise BR, FFN, HR oder MDR, senden. Es werden beispielsweise auch Sportsendungen durchaus mit Musik bereichert. Möchte der Benutzer einen Sportkanal auswählen und findet die Anwahl des Senders während der "Musikphase" statt, so ist dieser Rundfunksender schwer bzw. nicht als Sportkanal mit Sportübertragung identifizierbar und würde übergangen, da dem Benutzer während der Anwahl Musik zu Gehör gebracht wird, er jedoch für einen Sportsender typische Wortbeiträge erwartet.

Das RDS-Signal enthält ferner, zusätzlich zu den obengenannten Daten eine Information über die Programmart, eine sogenannte Programmartkennung, nachfolgen kurz als PTY bezeichnet, mittels derer 31 unterschiedliche Programmarten, wie beispielsweise Sportsender, Musiksender oder Nachrichtensender, erkannt werden können. Aus der EP 0 498 233 A2 sind Geräte bekannt, die eine "PTY-Funktionsebene" haben, in welcher eine PTY-Auswertung und eine PTY-Logik aktiviert wird. Wird diese Ebene aktiviert, so kann eine PTY-Kennung vorgewählt werden und das Band auf einen Sender mit entsprechender Kennung abgesucht werden. Bei erfolgreicher Suche wird anschließend die PTY-Kennung angezeigt, (z.B. Nachrichten, Pop, Sport usw.) Andererseits werden PTY-EON-Querverweise ausgewertet und eine Umschaltung kann automatisch auf Sender mit der vorgewählten Kennung erfolgen. Dieses System hat jedoch den Nachteil, daß der Benutzer nicht erkennen kann, welche anderen Programmarten zur Zeit empfangbar sind, da immer nur ein einzelner PTY durch die beschriebene PTY-Logik aktiviert oder deaktiviert wird.

Wurde die PTY-Logik nicht aktiviert, so wird die Programmartkennung, die in jeder RDS-Gruppe, d.h. ca. alle 87 ms gesendet wird, nicht ausgewertet und nicht angezeigt. Diese vorhandene Information wird auch nicht passiv gespeichert, d.h. nicht derart, daß nach PTY-Aktivierung sofort auf diese Information zurückgegriffen werden könnte. Die in EP 0 498 233 A2 beschriebene PTY-Logik ist daher sehr unkomfortabel und erfordert hohe Aufmerksamkeit des Benutzers bei der Bedienung, da dieser eine gewünschte PTY-Kennung jedesmal neu bestimmen muß.

### Darstellung der Erfindung, Aufgabe, Lösung, Vorteile

Es ist Aufgabe der vorliegenden Erfindung, ein verbessertes Verfahren und ein verbessertes RDS-Rundfunkempfangsgerät der obengenannten Art zur Verfügung zu stellen, welche die obengenannten Nachteile beseitigen.

Diese Aufgabe wird durch ein Verfahren der o.g. Art mit den in Anspruch 1 gekennzeichneten Merkmalen und durch einen RDS-Rundfunkempfänger der o.g. Art mit den in Anspruch 6 gekennzeichneten Merkmalen gelöst.

Dazu ist es erfindungsgemäß vorgesehen, daß im Alternativfrequenzspeicher zu jeder gespeicherten Alternativfrequenz (AF) ein zusätzliches Kennzeichen gespeichert wird, welches eine Vorzugs-Programmartkennung (PTY) des zugehörigen Rundfunkprogramms/-senders angibt.

Dies hat den Vorteil, daß durch Nutzung der Programmkennung (PTY) ein zusätzliches, vorbestimmbares Unterscheidungsmerkmal für den Senderaufruf aus dem Landschafts- bzw. Alternativfrequenzspeicher zur Verfügung steht. Dem Benutzer wird ein Zusatzfeature zur Verfügung gestellt, welches die Bedienung nach seinen individuellen Wüschen derart vereinfacht, daß er dem RDS-Empfangsgerät weniger Aufmerksamkeit bei der Sendersuche widmen muß und so beispielsweise ein Fahrer eines Kraftfahrzeuges mit RDS-Autoradio weniger vom Verkehr abgelenkt wird. Ferner können gemäß der obengenannten EBU-Spezifikation beispielsweise auch Nachrichtendurchsagen bei einem Musiksender temporär als "Nachrichten" gekennzeichnet werden. Gemäß dem erfindungsgemäßen Verfahren werden auch diese Aussendungen als von dem Benutzer gewünscht erkannt, sofern dieser als Programmkennung (PTY) "Nachrichten" vorbestimmt hat, obwohl es sich eigentlich um einen Musiksender handelt. Hierdurch erhöht sich in vorteilhafter Weise die dem Benutzer für seinen Programmkennungs-(PTY)-Wunsch zur Verfügung stehende Senderzahl.

Vorzugsweise Weitergestaltungen des Verfahrens sind in den Ansprüchen 2 bis 5 beschrieben.

Eine Auswahl eines neuen Rundfunksenders unmittelbar gemäß den Wünschen des Benutzers bzgl. der Programmart wird dadurch erzielt, daß die Alternativfrequenzen (AF) einer momentan am RDS-Rundfunkempfänger eingestellten Mutterfrequenz, deren Programmartkennungen (PTY) einer vorbestimmten Programmartkennung (PTY) entsprechen, auf prioritätshöhere Speicherplätze, d.h. vor solchen Alternativfrequenzen (AF) gespeichert werden, deren Programmartkennungen (PTY) des zugehörigen Rundfunksenders nicht der vorbestimmten Programmartkennung (PTY) entsprechen. Dadurch werden diese weiter vorne einsortierten Alternativfrequenzen bei einem Frequenzwechsel bevorzugt aufgerufen.

Wenn beispielsweise aufgrund mangelnder Qualität des Empfangssignals des gerade eingestellten Rundfunksenders ein Sprung zu einer Alternativfrequenz (AF) erfolgen soll, so wird in vorteilhafter Weise bevorzugt eine Alternativfrequenzen (AF) angesprungen, deren Programmkennung (PTY) bereits in einer zuvor durchgeführten Überprüfung als mit der vorbestimmten Programmkennung (PTY) des gerade eingestellten Rundfunksenders identisch bestätigt wurde.

Für einen bevorzugten Wechsel zu anderen Sendern, die gleichzeitig einer bestimmten Programmkettenidentifikation PI angehören, sind die Alternativfrequenzen (AF) im Alternativfrequenzspeicher (AF-Speicher) in einer ersten Sortierebene nach der jeweiligen Programmkettenidentifikation (PI) und in einer zweiten Sortierebene nach der Programmartkennung (PTY) gespeichert.

Zweckmäßigerweise wird die PTY-Kennung ständig erfaßt und direkt angezeigt wird und als Abstimmnilfe neben der Programmidentifikation genutzt.

Bei einem RDS-Rundfunkempfänger der o.g. Art ist es erfindungsgemäß vorgesehen, daß der Alternativfrequenzspeicher für jede Alternativfrequenz (AF) wenigstens einen zusätzlichen Speicherplatz aufweist zum Speichern von einem zusätzlichen Kennzeichen, welches die Programmartkennung (PTY) des zugehörigen Rundfunksenders angibt bzw. bestätigt.

Dies hat den Vorteil, daß durch Nutzung der PTY-Programmkennung ein zusätzliches, vorbestimmbares Unterscheidungsmerkmal für den Senderaufruf aus dem Landschafts- bzw. AF-Speicher zur Verfügung steht.

In einer vorteilhaften Weiterbildung der Erfindung stellt der RDS-Rundfunkempfänger nach einer vom Benutzer gesteuerten Abstimmung auf ein neues Programm die Programmartkennung (PTY) in einer Anzeigeeinheit dar.

### Kurze Beschreibung der Zeichnung

Nachfolgend wird die Erfindung unter Bezugnahme auf die Figuren näher erläutert. Diese zeigen in
- Fig. 1: ein schematisches Blockschaltbild einer bevorzugten Ausführungsform eines erfindungsgemäßen RDS-Rundfunkempfängers und
- Fig. 2: eine tabellarische Darstellung einer Speicherorganisation eines Alternativfrequenzspeichers einer bevorzugte Ausführungsform eines erfindungsgemäßen RDS-Rundfunkempfängers.

### Bester Weg zur Ausführung der Erfindung

Radio-Daten-System-(RDS)-Signale von Rundfunksendern enthalten zusätzlich eine Programmkennung (PTY-Kennung), welche die Programmart, wie beispielsweise Nachrichten, Popmusik oder Sport, identifiziert bzw. kennzeichnet.

Ein zusätzlich im Alternativfrequenzspeicher (AF-Speicher) vorgesehener Speicherraum, welcher die PTY-Kennung einer dieser Alternativfrequenz (AF) zugehörigen Rundfunksenders aufnimmt, stellt ein zusätzliches Kriterium für das Ablegen und Sortieren der Alternativfrequenzen (AF) im AF-Speicher zur Verfügung. Der Benutzer bestimmt am Rundfunkgerät einmal eine PTY-Kennung, welche seinem Programmwunsch für einen einzustellenden Rundfunksender am besten entspricht, beispielsweise die Programmart "Sport". Zur Auswahl werden alle Alternativfrequenzen (AF) im AF-Speicher automatisch derart geprüft, daß Alternativfrequenzen (AF) von Rundfunksendern, deren Programmkennung (PTY) dieser vorbestimmten Programmkennung (PTY) entsprechen mit höherer Priorität in einem Arbeitsspeicher abgespeichert, d.h. beispielsweise auf die oberen Speicherplätze und vor anderen Alternativfrequenzen (AF), deren Programmkennung (PTY) nicht der vorbestimmten Programmkennung (PTY) entsprechen oder noch nicht bekannt sind. Alternativ können letztere Alternativfrequenzen (AF) auch völlig ignoriert und nicht im AF-Speicher abgespeichert werden.

Bei einem manuell vom Benutzer, beispielsweise über die Handabstimmwippe, oder automatisch, beispielsweise wegen schlechter Empfangsqualität des momentan eingestellten Rundfunksenders, ausgelösten Wechsel zur prioritätshöchsten Alternativfrequenz (AF), beispielsweise der Alternativfrequenz (AF) im Speicherplatz 1 des AF-Speichers, wird somit direkt eine Alternativfrequenz (AF) angesprungen, deren Rundfunksender eine vom Benutzer bevorzugtes Programmart ausstrahlt. Der Benutzer muß nicht mehr kurz das Programm anhören und anschließend entscheiden, ob die Programmart seinen Wünschen entspricht. Vielmehr erfolgt diese Auswahl automatisch bereits vorab beim Pflegen des AF-Speichers.

Die Programmkennung (PTY) kann wechselnd mit dem Sendernamen (PS) oder parallel angezeigt werden. Auch bei Sendern die durch Suchlauf oder Stationsaufruf angewählt wurden ist eine zumindest temporäre Anzeige der Programmkennung (PTY) möglich und hilfreich.

Da die Programmkennung-(PTY)-Information 5X häufiger gesendet wird als der Sendername (PS), ist die Programmkennung (PTY) bereits sicher eingetroffen wenn der Sendername (PS) erscheint. Wird nun diese Programmart angezeigt, so läßt sich die Lieblingsprogrammart einfacher auswählen, da z. B. auch Sportsendungen durchaus mit Musik bereichert werden. Findet die Anwahl des Senders während der "Musikphase" statt, so ist dieser Sender schwer als Sportkanal mit Sportübertragung identifizierbar und würde übergangen.

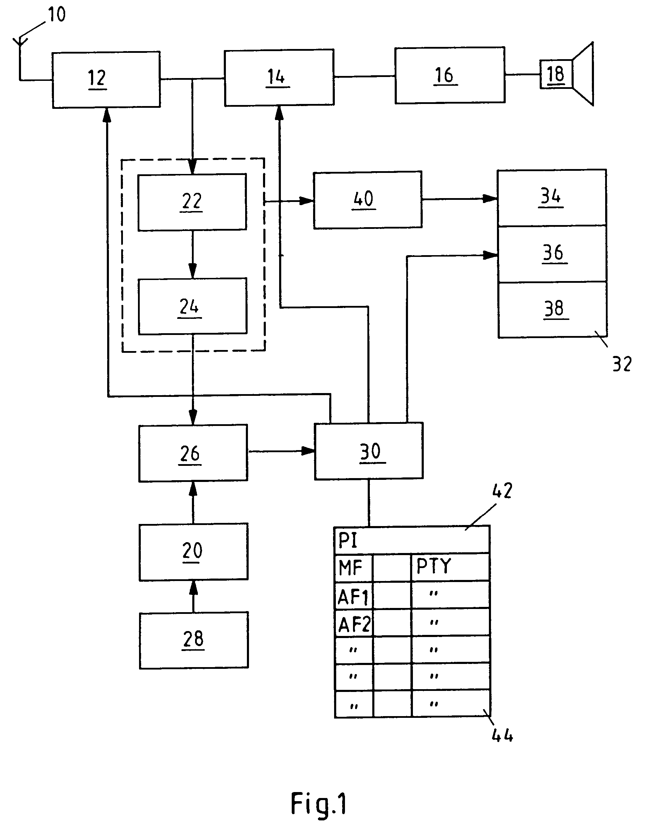

Die in Figur 1 dargestellte bevorzugte Ausführungsform eines erfindungsgemäßen RDS-Rundfunkempfängers umfaßt eine Antenne 10, ein Empfangsteil 12, eine Mute-Einrichtung 14 und ein Ausgabeteil 16 mit Lautsprecher 18. Die Mute-Einrichtung 14 schaltet wahlweise die Wiedergabe stumm.

Nach dem Empfangsteil werden von einem RDS-Dekoder 22 und einem Programmkennungs-(PTY)-Dekoder 24 aus dem empfangenen Signal das RDS-Signal und die Programmkennung (PTY) ausgewertet. In einem Vergleicher 26 wird der Ausgang des PTY-Dekoders 24 mit einem Ausgang eines Programmkennungs-(PTY)-Generators 20 verglichen, welcher entsprechend einer Benutzereingabe an einem Bedienteil 28 eine Programmkennung (PTY) erzeugt, und der Ausgang des Vergleichers 26 wird einer Steuereinheit 30 zugeführt.

Die Steuereinheit 30 steuert das Empfangsteil 12, die Mute-Einrichtung 14 und eine Anzeige-Einheit 32 mit Frequenzanzeige 34, Sendernamenanzeige 36 zum Anzeigen einer Programmart (PS) und Programmkennungs-(PTY)-Anzeige 38. Die Anzeige-Einheit 32 wird ferner von einer Anzeige-Steuereinheit 40 angesteuert.

Zur entsprechenden Auswahl der besten momentanen Empfangsfrequenz und entsprechendem Ansteuern des Empfangsteiles 12 ist die Steuereinheit mit einem Alternativfrequenzspeicher 42 als Arbeitsspeicher verbunden. Dieser enthält den PI-Code (PI), die Mutterfrequenz (MF) und verschiedene Alternativfrequenzen (AF1, AF2,...usw.). Je nach Empfangssituation wählt die Steuereinheit 30 eine Frequenz aus dem Speicher 42 aus und steuert das Empfangsteil 12 derart, daß dieses die gewünschte Frequenz aus dem von der Antenne 10 empfangenen Signal selektiert.

Zum Prüfen eines PI-Code einer Alternativfrequenz, welche möglicherweise angesprungen werden soll, schaltet die Steuereinheit 30 über die Mute-Einrichtung 14 die Wiedergabe stumm, ändert die im Empfangsteil selektierte Empfangsfrequenz, prüft das RDS-Signal und den PI-Code und schaltet, je nach Ergebnis der Prüfung, auf der ursprünglichen Frequenz oder auf der Alternativfrequenz wieder laut, d.h. deaktiviert die Mute-Einrichtung 14.

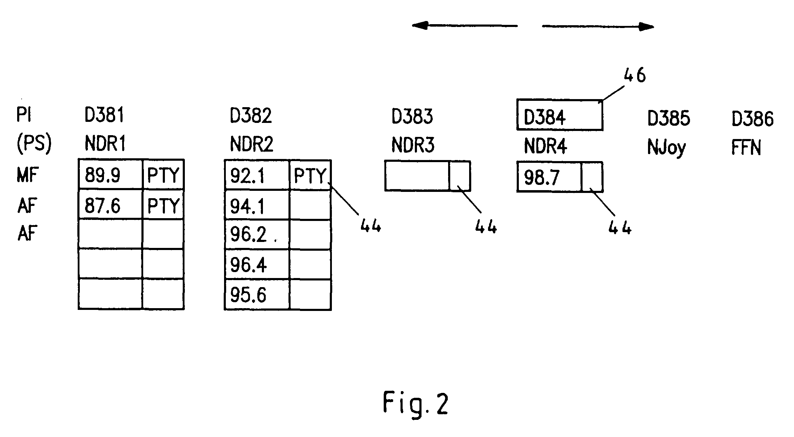

Figur 2 zeigt schematisch und beispielhaft einen Landschaftsspeicher. Dieser enthält sortiert nach verschiedenen PI-Codes (D381, D382, ... usw.) Mutterfrequenz (MF: 89.9 usw.), Programmname (PS: NDR1, NDR2, ... FFN usw.) und Alternativfrequenzen (AF: 87.6, ... usw. oder 94.1, 96.2 ... usw.). Zusätzlich ist zu jeder Mutter- und Alternativfrequenz ein weiterer Speicherplatz 44 vorgesehen, welcher die Programmkennung (PTY) der jeweiligen Frequenz enthält, sofern diese bekannt ist.

Die Sortierung im Landschafts- oder Hintergrundspeicher erfolgt derart, daß Sender, deren abgespeicherte Mutterfrequenz (MF) einen Programmkennungs-(PTY)-Eintrag haben eine höhere Priorität bekommen und bei sequentieller Anwahl, z.B. Blättern, die Sender dem PI-Code folgend bevorzugt ausgewählt werden. Geblättert wird in der Figur 2 horizontal, wobei in der Darstellung momentan der von links vierte PI-Code 46 ausgewählt ist. Dies ist durch eine entsprechende Umrahmung des PI-Codes "D384" angedeutet. Von hier aus kann nun abwärts (nach links) oder aufwärts (nach rechts) geblättert werden.

Zusammenfassend wird also eine im RDS-Signal zusätzlich vorhandene PTY-Kennung im AF-Speicher zusätzlich abgespeichert und als Sortierkriterium für die AF im AF-Speicher zusätzlich und als Auswahlkriterium verwendet.

## Patentansprüche

1. Verfahren zum Ablegen und Sortieren von Alternativfrequenzen (AF) in einem Alternativfrequenzspeicher eines Radio-Daten-System-(RDS)-Rundfunkempfängers,
dadurch gekennzeichnet, daß
im Alternativfrequenzspeicher zu jeder gespeicherten Alternativfrequenz (AF) ein zusätzliches Kennzeichen gespeichert wird, welches eine Programmartkennung (PTY) des zugehörigen Rundfunkprogramms/-senders angibt.

2. Verfahren nach Anspruch 1,
dadurch gekennzeichnet, daß
die Alternativfrequenzen (AF) einer momentan am RDS-Rundfunkempfänger eingestellten Mutterfrequenz, deren Programmartkennungen (PTY) einer vorbestimmten Programmartkennung (PTY) entsprechen, auf prioritätshöhere Speicherplätze, d.h. vor solchen Alternativfrequenzen (AF) gespeichert werden, deren Programmartkennungen (PTY) des zugehörigen Rundfunksenders nicht der vorbestimmten Programmartkennung (PTY) entsprechen.

3. Verfahren nach Anspruch 1 oder 2,
dadurch gekennzeichnet, daß
bei einem Sprung zu einer Alternativfrequenz (AF) aufgrund mangelnder Qualität des Empfangs eines gerade eingestellten Rundfunksenders diejenigen Alternativfrequenzen (AF) bevorzugt angesprungen werden, deren zugehöriger Rundfunksender eine Programmartkennung (PTY) aufweist, die einer vorbestimmten Programmartkennung (PTY) entspricht.

4. Verfahren nach einem der vorhergehenden Ansprüche,
dadurch gekennzeichnet, daß
die Alternativfrequenzen (AF) im Alternativfrequenzspeicher (AF-Speicher) in einer ersten Sortierebene nach der jeweiligen Programmkettenidentifikationen (PI) und in einer zweiten Sortierebene nach der Programmartkennung (PTY) gespeicherten sind.

5. Verfahren nach einem der vorhergehenden Ansprüche,
dadurch gekennzeichnet, daß
die PTY-Kennung ständig erfaßt und direkt angezeigt wird und als Abstimmhilfe neben der Programmidentifikation genutzt wird.

6. RDS-Rundfunkempfänger mit Alternativfrequenzspeicher (42),
dadurch gekennzeichnet, daß
der Alternativfrequenzspeicher (42) für jede Alternativfrequenz (AF) wenigstens einen zusätzlichen Speicherplatz (44) aufweist zum Speichern von einem zusätzlichen Kennzeichen, welches die Programmartkennung (PTY) des zugehörigen Rundfunksenders/-programms angibt.

7. RDS-Rundfunkempfänger nach Anspruch 6,
dadurch gekennzeichnet, daß
dieser nach einer vom Benutzer gesteuerten Abstimmung auf ein neues Programm die Programmartkennung (PTY) in einer Anzeigeeinheit darstellt.
